# EUROPEAN PATENT APPLICATION

(11) **EP 2 348 431 A1**
(43) Date of publication of application: **27.07.2011**
(21) Application number: 10252095.4
(22) Date of filing: 10.12.2010
(51) Int. Cl.: G06F 17/50

(54) **Method and apparatus to efficiently generate a processor architecture model**

(30) Priority: 23.12.2009 US 646541
(71) Applicant: Intel Corporation, Santa Clara, CA 95052 (US)
(72) Inventor: Bracy, Anne W., St Louis, MO 63130 (US); Madhav, Mahesh, Portland OR 97212 (US); Wang, Hong, Santa Clara, CA 95054 (US)
(74) Representative: Beresford, Keith Denis Lewis

(57) **Abstract**

A method and apparatus for efficiently generating a processor architecture model that accurately predicts performance of the processor for minimizing simulation time are described. In one embodiment, the method comprises: identifying a performance benchmark of a processor; sampling a portion of a design space for the identified performance benchmark; simulating the sampled portion of the design space to generate training data; generating a processor performance model from the training data by modifying the training data to predict an entire design space; and predicting performance of the processor for the entire design space by executing the processor performance model.

## Description

### FIELD OF THE INVENTION

Embodiments of the invention relate generally to the field of processors, and more particularly to a method and apparatus for efficiently generating a processor architecture model that accurately predicts performance of the processor for minimizing simulation time.

### BACKGROUND

As processor architectures become more complicated and large in transistor count compared to previous generation processor architectures, simulating such processors to determine their performance at various conditions is time and processor clock cycle intensive. Such time intensive computations create a barrier to exhaustive design space exploration of new and existing processor architectural features. Without thorough design space exploration it is not possible to select the best possible processor design or configuration for a target workload environment.

For example, exploring the performance of a processor for a suite of target benchmarks (e.g., Microsoft Word™2007, Microsoft Excel™ 2007, Microsoft Internet Explorer™ etc.), or part of the benchmark (e.g., a subset of features of Microsoft Word™ 2007, etc.) to be explored at across 10 different processor simulator parameters (e.g., instruction window (IW) size, data cache unit (DCU) size, etc.) each with 5 possible values (e.g., 48, 64, 80, 96, or 112 entries for instruction window (also called re-order buffer) size; or 2, 4, 8, 16, or 32KB for data cache size) would require approximately 10 billion simulation runs. The term trace is generally defined as a subset of workload (interchangeably used for the term benchmark) to be executed on a processor.

Assuming each trace takes 3 hours to simulate on one processor and that there are 5000 processors dedicated for simulating the 1000 traces, then these 5000 dedicated processors will take over 700 years of processor simulation time to determine the performance of the processor architecture for the 1000 traces. Design space exploration is not feasible with such processor simulation time.

While simulations can be replaced with processor performance predicting models, such models are benchmark specific in terms of their creation, accuracy, and speed. Exploring processor design space using a new benchmark requires developing a new performance predicting model and then using that model to predict processor performance (measured as number of instructions executed per cycle (IPC) and/or power consumption in Watts) for that benchmark over various configurations of that benchmark. An approach which leverages custom models does not scale in terms of both speed and accuracy when determining processor architecture performance and power consumption envelopes across a wide range of benchmarks (e.g., greater than 1000 benchmarks).

### BRIEF DESCRIPTION OF THE DRAWINGS

Embodiments of the invention will be understood more fully from the detailed description given below and from the accompanying drawings of various embodiments of the invention, which, however, should not be taken to limit the invention to the specific embodiments, but are for explanation and understanding only.
Fig. 1 A is a high-level flow chart for efficiently generating a processor performance model for predicting processor performance, according to one embodiment of the invention.
Fig. 1 B is a table with simulator parameters and their respective values, according to one embodiment of the invention
Fig. 2 is a graph showing performance prediction error sensitivity to amount of training data, according to one embodiment of the invention.
Fig. 3 is detailed flow chart for generating the processor performance model for multiple benchmarks, according to one embodiment of the invention.
Fig. 4A is a non-binary feature-label matrix for generating the processor performance model, according to one embodiment of the invention.
Fig. 4B is a binary feature-label matrix for generating the processor performance model, according to one embodiment of the invention.
Fig. 5 is a system showing hardware associated with efficiently generating the processor architecture model, according to one embodiment of the invention.

### DETAILED DESCRIPTION

Embodiments of the invention relate to a method and apparatus for efficiently generating a single processor architecture model that accurately predicts performance of the processor by minimizing simulation time across a large magnitude (e.g., greater than 1000) of processor benchmarks.

In one embodiment, the processor benchmarks are incorporated into a feature-label pair, which is discussed later, that allows the processor performance prediction model to predict power consumption and processor performance for a wide range of benchmarks. Embodiments herein use the term performance and power interchangeably since the processor performance model can predict either or both the processor performance in terms of IPC and processor power consumption in Watts.

In one embodiment, the wide range of benchmarks range from an unlimited number of benchmarks to a small sample of benchmarks (including a single benchmark). Furthermore, the method and apparatus for efficiently generating the single processor architecture performance prediction model provides for a low error rate (e.g., less than 3% error compared to actual benchmark simulations) and high prediction speed (e.g., minutes instead of years).

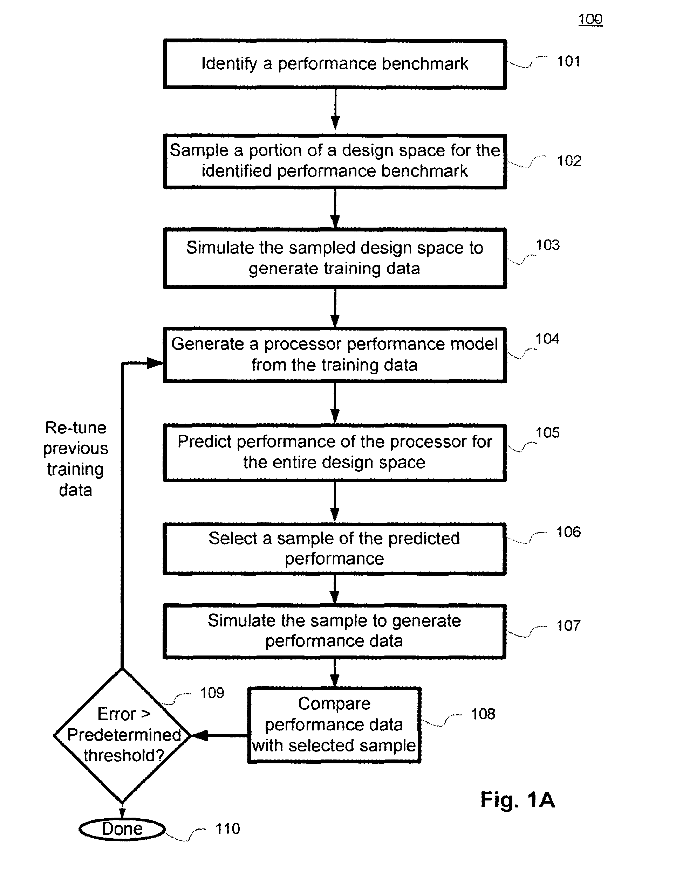

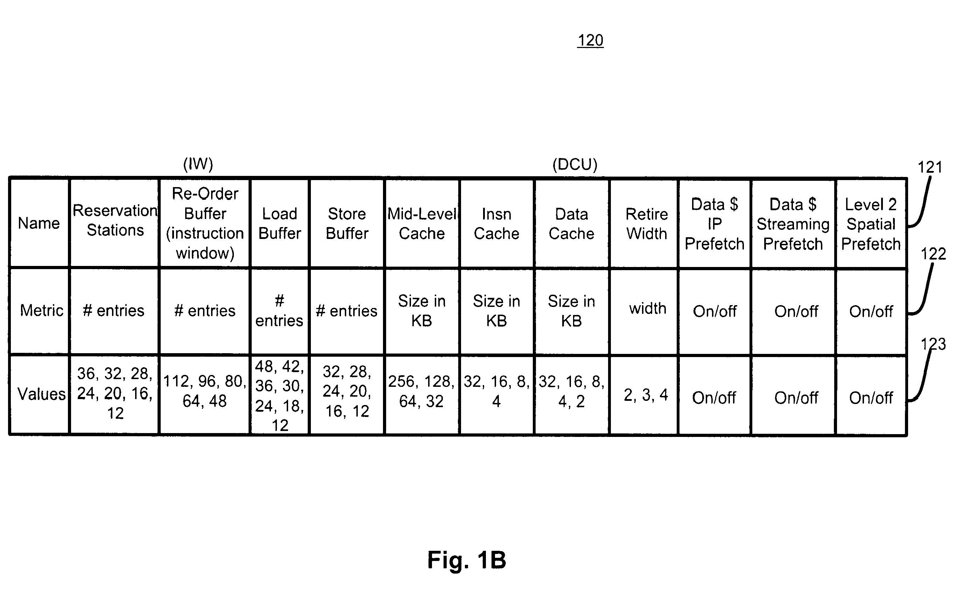

Fig. 1 is a flow chart 100 for efficiently generating a processor architecture model, according to one embodiment of the invention. At block 101 a performance benchmark of a processor is identified. In one embodiment, one or more performance benchmarks are identified for generating the performance prediction model. In one embodiment, the benchmarks include domains such as multimedia, office, gaming, and server applications. In one embodiment, the processor is a single core processor. In other embodiments, the processor is a multi-core processor. Embodiments of the invention are not limited to any specific processor architecture.

At block 102, a portion of a design space for the identified performance benchmark is sampled. In one embodiment, sampling of the portion of the design space entails generating a large number of random configurations of the given processor. In one embodiment, for each configuration a value for each simulator parameter is randomly chosen. A configuration of a processor means an architecture setup for the processor.

For example, one configuration of a processor may have a level-one cache memory which is the same size as the level-two cache memory. In another configuration, a level-one cache is smaller in size than a level-two cache. Similarly, a configuration may have a single processor core, while other configurations may have more than one processor core i.e., a multi-core processor. The above mentioned configurations are examples only and are not intended to limit the processor configurations to those examples.

A simulator parameter, in one embodiment, determines the size of the processor architectural design space. In one embodiment, the smaller the design space, the more accurate the performance prediction model for the processor is.

An example of a simulator parameter, in one embodiment, is size of a cache memory in the processor. Generally, a level-one cache is smaller in size than a level-two cache. This means that the simulator parameter value for a level-one cache should be set at a value lower than the simulator parameter value for a level-two cache for generating an accurate performance prediction model. If the reverse is done, then the performance prediction model may be less accurate because its training data includes processor configurations in which the level-one cache is larger than the level-two cache, which does not reflect the way cache memory is organized in the real world processors. In such an embodiment, a portion of the training data that generated the performance prediction model is wasted training data for building the performance prediction model. One reason the training data is considered wasted training data is because in the real world cache memory is not organized with level-one cache size being larger than level-two cache size because such organization does not yield higher performance for the processor.

In one embodiment, each simulation parameter is assigned a value from a predetermined range of values. Fig. 1B illustrates a table 120 with simulator parameters and their respective values, according to one embodiment of the invention. For example, in one embodiment, row 121 lists simulator parameters, row 122 lists the metrics associated with the simulator parameters e.g., number of parameters, size of parameters, status of parameters, and row 123 includes the predetermined range of the simulator parameter values. In one embodiment, each simulation parameter is randomly assigned a value from an unordered set of possible values spaced equally across a range of possible values. In one embodiment, the range is a predetermined range of possible values.

So as not to obscure the following embodiments, size of instruction window (IW) which is also called a re-order buffer and which is expressed as a number of entries, and size of data cache unit (DCU) which is expressed in KB are used for explaining the method for efficiently generating the processor architecture performance prediction model. Other simulator parameters such as processor reservations stations, load buffer, store buffer, mid-level cache, instruction cache, retire width etc., with their own predetermined range of possible values can also be used for generating the processor architecture performance prediction model.

In one embodiment, if the predetermined range of possible values in the IW of a processor is 48 to 112 (as shown in row 123), and the increment value is 16, then the unordered set of parameter values would be {48, 64, 80, 96, 112}. In another embodiment, simulation parameters are assigned from an unordered set of possible values which grow quadratically across the range of possible values. For example, if the predetermined range of the size of the DCU of the processor is 2KB to 32KB, then the unordered set of parameter values would be {2, 4, 8, 16, or 32 KB}.

Referring back to Fig. 1A. at block 103 training data for the processor performance model is generated by simulating the sampled design space. In one embodiment, rather than creating multiple processor models, one for each benchmark, a single processor model is generated for the multiple benchmarks. A single processor model allows for efficient prediction of a large number of benchmarks (e.g., over 1000 benchmarks) without the need to generate customized prediction models for individual benchmarks.

In one embodiment, the training data includes a benchmark number (e.g., 100 to represent the 100^{th} benchmark), the type of benchmark that was simulated (e.g., Microsoft Words™ 2007), simulation parameter values (e.g., size of level-one and level-two cache memories), and the IPC (e.g., number of instructions executed for that particular type of benchmark that was simulated). Such an embodiment allows for training a single processor model that incorporates information about multiple benchmarks.

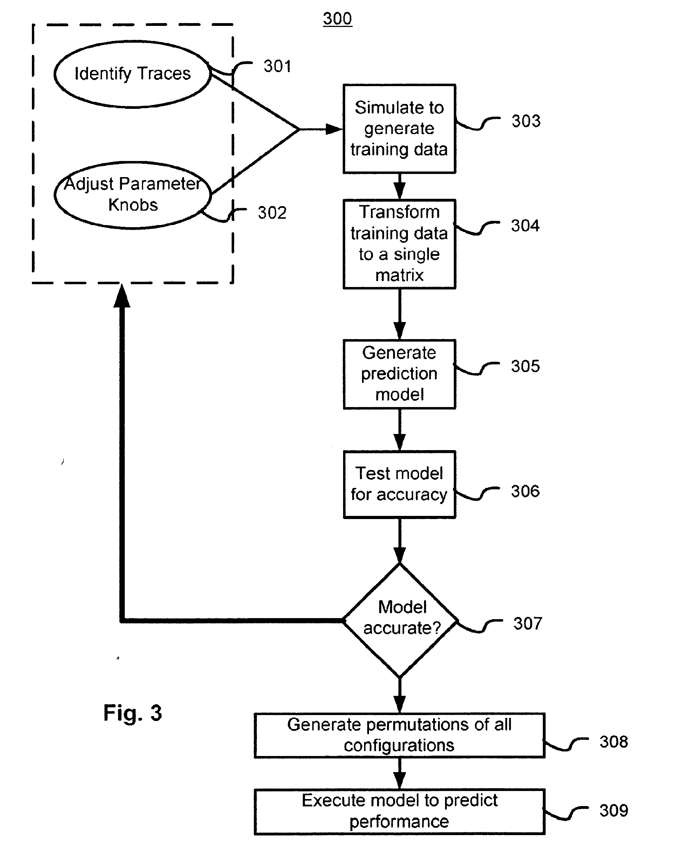

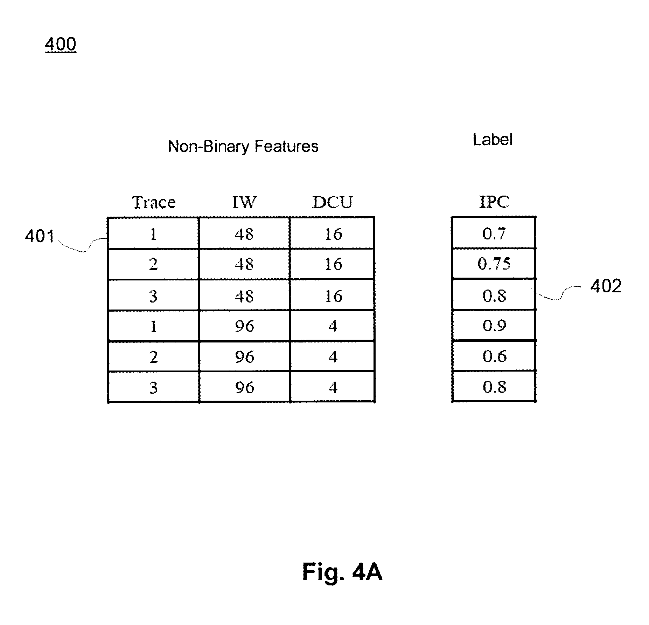

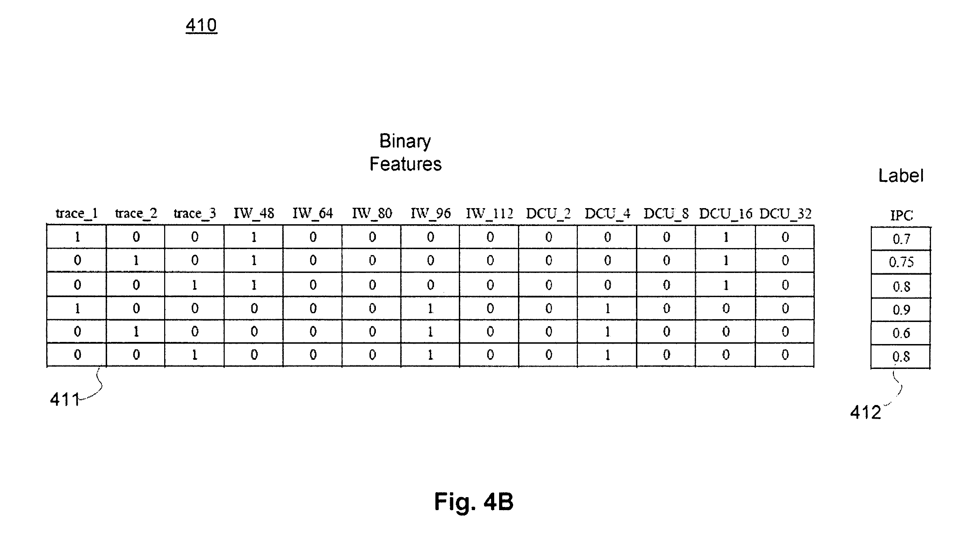

At block 104, a single processor performance model is generated from the training data from block 103. In one embodiment, the performance model is generated by executing a statistical method. In one embodiment, the processor performance model is a single processor performance model. In one embodiment, the statistical method is a Vowpal Wabbit (VW) statistical method for executing the training data from block 103 to generate the processor performance prediction model. In other embodiments, other statistical methods may be used to generate the performance prediction model from the training data from block 103 without changing the principal of the embodiments. Details of generating the performance prediction model are discussed later in reference to Fig. 3, Fig. 4A, and Fig. 4B.

Referring back to Fig. 1A, at block 105, performance of the processor is predicted for an entire design space by executing the single processor performance prediction model. The processor performance prediction model allows for predicting the performance and power of unseen processor configurations. In one embodiment, a complete list of all processor configurations is generated by identifying all permutations of every processor configuration. These permutations, in one embodiment, are identified by adjusting knobs for the simulator parameters. In one embodiment, the complete list of all processor configurations is input to the processor performance model. The resulting prediction is the exhaustive design space for the processor.

In one embodiment, the knobs are also adjusted to reduce the error in the prediction when compared with real simulation data. In such an embodiment, the performance prediction model is re-trained and a newer and more accurate processor performance prediction model is generated. In one embodiment, the performance prediction model is re-trained by removing un-correlated parameters from the training data i.e., re-tuning previous training data. Correlated and uncorrelated training data is discussed later. In one embodiment, if the error is too high (e.g., greater than 10%) more training data is gathered, instead of re-training existing data, to generate a newer and more accurate processor prediction model.

At block 106, a sample of the predicted performance result of the processor is selected. The sample, in one embodiment, represents the stimulus for the performance benchmark identified at block 101. In one embodiment, the selection process is done to narrow down on a particular performance result and on the knobs, parameter, and benchmark associated with that performance result. In one embodiment, the selection is based on a cost metric and a benefit metric. If only one metric is provided, the ability to select configurations of interest is limited.

For example, in one embodiment, thousands (even tens of thousands) of decremented processor configurations can be identified from an initial processor design point that consumes approximately 80% of the processor's original power. A processor's original power means the power consumption of the processor when the processor is not decremented. The power savings of 20% by the decremented processor as compared with the original process is the benefit metric. The cost metric is the performance degradation associated with the decremented processor design when compared with the original processor design. By combining the benefit and cost metrics, in one embodiment, an optimum performing processor configuration with the desired power savings is achieved.

At block 107, the selected sample is simulated to better understand the particular sample for the performance benchmark. In one embodiment, actual performance data from the simulator is generated.

At block 108, the performance data generated by simulating the selected sample is compared with the predicted performance for that sample. The comparing, in one embodiment, allows for tuning the processor performance model. In one embodiment, the comparing generates an error. The error, in one embodiment, is defined as a difference between the predicted performance and the actual simulated performance of the processor for a given sample. In other embodiments, other expressions of error may be used without changing the principle of the embodiments.

At block 109, a determination is made whether the error generated from the comparing is larger than a predetermined threshold. In one embodiment, the predetermined threshold is 4%. In other embodiments, lower or higher threshold values may be used to trade-off between accuracy of the performance prediction model and speed of predicting the processor performance.

In one embodiment, the performance prediction model is tuned (via knobs discussed in reference to block 105) to be closer to simulated results if the error exceeds a predetermined threshold. In one embodiment, tuning of the performance prediction model occurs by removing the training data for a particular parameter which is uncorrelated to performance of the processor.

For example, in one embodiment, if the processor performance is found to be insensitive to the size of the IW i.e., the size of IW is uncorrelated to the performance of the processor then the size of the IW is not used as a training parameter for creating/generating the performance prediction model of the processor. In such an embodiment, removing the size parameter of IW reduces the error of the performance prediction model because the performance prediction model no longer requires that it learn patterns in the training data for which no reliable pattern can be learned. In one embodiment, if the error is less than the predetermined threshold then at block 110 the prediction of the processor performance is complete.

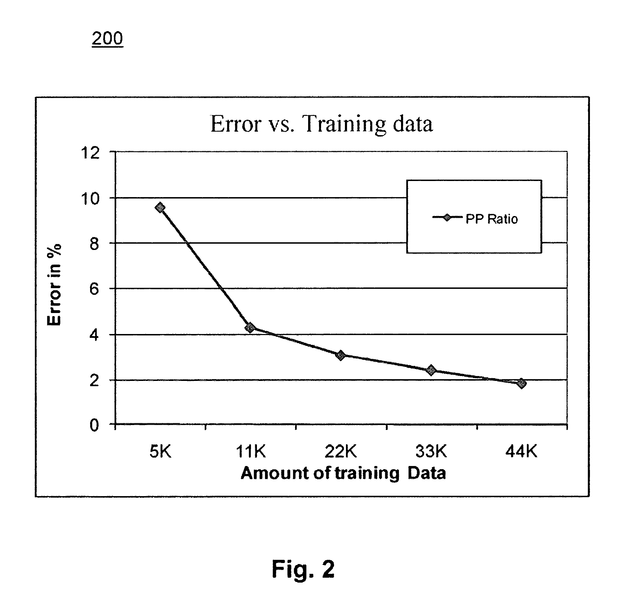

Fig. 2 is a graph 200 showing performance prediction error sensitivity to training data, according to one embodiment of the invention. The x-axis is the amount of training data used to generate the performance prediction model. The y-axis is the error rate in percentage. The graph shows that the error in predicting processor performance reduces as the number of training data is increased. In this example, an error rate of 4% results from approximately 11K of training data used for predicting processor performance.

Fig. 3 is a detailed flow chart 300 for generating a processor performance predicting model for multiple benchmarks, according to one embodiment of the invention. In one embodiment, at block 301 traces are identified. At block 302, knobs are adjusted for the simulator parameters. At block 303, the simulator receives the identified traces and the simulator parameters. The simulator simulates the identified traces with simulator parameters to generate training data for each trace and parameter. Blocks 301-303 were discussed in detail in reference to Fig. 1.

Referring back to Fig. 3, at block 304, the training data consisting of multiple files (e.g., thousands of files) are reorganized into a single matrix having feature-label pairs by converting the training data to the single matrix. In one embodiment, the feature-label pairs are associated with the identified performance benchmark.

An example of the matrix is shown in embodiments illustrated by Fig. 4A and Fig. 4B. Fig. 4A is a non-binary single matrix 400 having features 401 and labels 402, according to one embodiment of the invention. To not obscure the embodiments, the simulator parameters of IW and DCU are used to explain the single matrix. In one embodiment, all features and labels are organized in rows and columns in 401 and 402 of the single matrix 400. In one embodiment, the features of IW and DCU are paired in 401 and 411 of Fig. 4A and Fig. 4B respectively. These features include various random configurations (e.g., 48 and 96 for the IW and 16 and 4 for the DCU) from a set of predetermined values (See 123 of Fig. 1B).

In the embodiment of Fig. 4A, three traces are considered which result in six random configurations, two for each trace. In one embodiment, the labels 402 are assigned to each row of the features 401. In the embodiments of Fig. 4A and Fig. 4B, relative IPC are the labels in 402 and 412 which are assigned to a row of features 401 and 411. Relative IPC means the IPC of a processor configuration executing a trace when compared with an original processor executing the same trace and having an IPC of 1.00.

Fig 4B is a binary single matrix 410 having features 411 and labels 412, according to one embodiment of the invention. In one embodiment, features 411 in Fig. 4B include the trace IW and DCU in binary form. In one embodiment, feature pairing bypasses the need for explicit disclosure of relationships between simulator parameters (i.e., level of correlation between the simulator parameters) to provide a training data that does not need to know which processor parameters matter least or most to performance of the processor.

In one embodiment, the single matrix 410 is a binary form of the non-binary single matrix 400 of Fig. 4A. In one embodiment, the binary single matrix 410 allows for a more accurate performance prediction model generation by VW statistical method than via a non-binary single matrix 400. One reason for more accurate prediction modeling via the binary single matrix 410 is that the binarization of the single matrix allows the non-linear behavior of the features 411 on the processor performance to be captured by the otherwise linear VW statistical method.

For example, in one embodiment instead of using a single feature for the DCU size with several possible values (e.g., 2, 4, 8, 16, 32 KB), a single feature for each possible setting (DCU_2, DCU_4, DCU_8, DCU_16, DCU_32) is used. In such an embodiment, individual features for each possible parameter value allows for a non-linear relationship between various values of the same processor parameter and performance of the processor. In one embodiment, in the original non-binary form (e.g., Fig. 4A), the VW statistical method must learn a single linear function between the size of the DCU, for example, and the performance of the processor. But the relationship between the DCU and the performance of the processor, in one embodiment, may not be linear—perhaps performance increases when the DCU size increases from an 8KB to a 16KB size but performance remains constant from a 16KB to a 32KB DCU size. In such an embodiment, no linear function exists for expressing the relationship between the DCU size and the processor performance across all three DCU sizes. However, if the features are binarized in a single matrix with binary features, the VW statistical method learns a linear function per DCU size. Therefore, in one embodiment, the relationship between these three DCU sizes and the processor performance can be expressed by three linear functions which make the model more accurate.

Referring back to Fig. 3, the single matrix (400 of Fig. 4A or 410 of Fig. 4B) generated at block 304 is then executed on a statistical application at block 305. In one embodiment, the statistical application executes a VW statistical method to generate a performance prediction model. In one embodiment, the statistical method assigns weights for every feature (401 of Fig. 4A and 411 of Fig. 4B) in the matrix generated at block 304. In one embodiment, the sum of the weights assigned to each feature for each row of input data is the label (401 of Fig. 4A and 412 of Fig. 4B) corresponding to that row. In one embodiment, the statistical method assigns weights to features to minimize the squared error of the label. In one embodiment, if a simulator parameter is highly correlated with the processor performance across all benchmarks then a large weight (e.g., 1.0) is assigned to that feature. In one embodiment, if a parameter is uncorrelated to the processor performance then a small weight (possibly 0) is assigned to that feature.

In one embodiment, the statistical method incorporates quadratic feature pairing. In such an embodiment, weights are not only assigned to individual features but also to combinations of two features. For example, a weight is assigned to the size of the DCU, the size of the instruction cache (See Fig. 1 B), and a combination of the DCU and the instruction cache. In such an embodiment, the weight assigned to the combination of the two parameters captures second-order effects such as the interplay of any two specific configurations (e.g., the instruction cache size and DCU size). In one embodiment, the second-order effects make the performance prediction model more accurate resulting in smaller error.

Quadratic feature pairing has several benefits for predicting processor performance. Two exemplary benefits are discussed for illustration purposes.

First, in one embodiment, when the features paired are trace and parameter pairs, the feature pairing assists with learning trace-specific patterns by assigning appropriate weights to the parameters based on the impact of the parameter in learning the model for a trace.

For example, in one embodiment, a matrix includes three traces, X, Y, and Z. In one embodiment, trace X shows better processor performance from a large DCU size (e.g., 32 KB) alone i.e., trace X shows no performance sensitivity to the size of IW. No weight will be assigned to IW for trace X. In the above example, trace Y may provide better processor performance if equal weights are assigned to both the DCU and the IW sizes because both these parameters impact performance, according to one embodiment. Similarly, trace Z may show no additional processor performance benefit from both the DCU or the IW sizes and so no weight is assigned to either parameter for trace Z, according to one embodiment.

Second, in one embodiment, when the features which are paired are both parameters (unlike trace and parameter pairs discussed above) the model learns how the processor parameters affect one another.

For example, in one embodiment, features paired are a level-one cache and a level-two cache. Usually a larger level-two cache than a level-one cache results in better processor performance resulting in assigning more weight to level-one cache relative to level-two cache. But, in an embodiment where the level-one cache is already large, then the added benefit of even a larger level-two cache would be smaller than the case where level-one cache is small to begin with. By pairing the above cache features, the affect of the parameters on one another is determined for more accurate weight assignment to the above parameters for model generation.

In one embodiment, the performance prediction model assigns weights not only to a particular feature (e.g., DCU size) but also to the pair of that feature and the benchmark of each row of data (e.g., (DCU size, trace 1), (DCU size, trace2)) to determine whether a parameter typically affects all benchmarks similarly or uniquely. In such an embodiment, the model uses the determination to better guess the performance of a previously unseen processor-benchmark pairing of feature and label.

For example, in one embodiment when a simulator parameter is highly correlated with the processor performance for some benchmarks, a weight is placed on those parameter-trace feature pairs. In such an embodiment, when the processor performance is predicted for a known benchmark on previously unseen processor architecture, the performance prediction model knows for each simulator parameter whether the parameter typically affects all benchmarks similarly (i.e., a large weight is found on just the feature) or uniquely depending on the benchmark (i.e., a large weight is found only on the feature-trace pairs associated with the affected benchmarks). Such knowledge improves prediction of performance for an unseen processor.

In one embodiment, the statistical method models the relationship between the features and the labels (See Fig. 4) using cubic splines. Cubic splines are non-linear curves that are fit to the training data. In such an embodiment, a number of knots (or dividers) for fitting a spline for each feature are specified. In one embodiment, the spline is divided by the specified number of knots and a non-linear curve is learned between each knot. For example, if a spline has 2 knots, there will be three separately learned curves across the spline. In one embodiment, more knots can create a more powerful function between a feature and a label, but using too many knots may risk over-fitting the statistical performance prediction model to the training data.

For example, in one embodiment if there are 5 possible values for a particular parameter and the spline is not split with any knots, the non-linear relationship of the parameters to the feature makes it hard to fit all the data points on a single line. The term hard refers to how close the data points are to the spline. In one embodiment, the spline is split into 5 knots for fitting each data point on its own line. In such a case, the fitting will be too sensitive to the training data to provide accurate estimates for unseen data points.

Referring back to Fig. 3, at block 306 the training data from the initial random sampling used to create the statistical model of the processor is tested. In one embodiment, an N-fold cross-validation is performed to test the accuracy of the model. In one embodiment, N is 5. In other embodiments, fewer or more number of cross-validations may be performed to test the accuracy of the model. The more the number of cross-validations, the higher is a confidence level in the accuracy of the model.

For example, for an embodiment with N=5, the sampled data is divided into five equal parts. In one embodiment, four parts of the sampled data are used to train the performance prediction model, and the fifth part is used as testing data to measure the error of the model's predictions. In one embodiment, the above method is performed five times - each time using a different portion of the sampled data for testing. Error is then computed for every time the cross-validation is performed. In one embodiment, an average error is generated to indicate the percentage of error likely to be present when the performance prediction model is used to predict unseen configurations.

At block 307, a determination is made about the accuracy of the model. In one embodiment, if the average error is higher than a predetermined threshold (e.g., 4%), then re-training of data is done by performing the method associated with blocks 301-302.

In one embodiment, in the re-sampling phase (blocks 301-302) some simulator parameters are reviewed for improving accuracy based on their correlation to processor performance as compared to other simulator parameters. In one embodiment, parameters that are highly correlated (either positively or negatively) improve the accuracy of the model generated by the statistical method.

A highly correlated parameter is one that affects the performance of the processor directly. An un-correlated parameter is one that does not affect the performance of the processor.

In one embodiment, the simulator parameters that are un-correlated to the processor performance are discarded because such un-correlated parameters introduce noise to the performance prediction model and thus reduce its accuracy. In one embodiment, the re-training process discussed above is repeated a number of times to achieve a desired percentage error.

At block 307, if the average error is determined to be less than the predetermined threshold, then permutations of all processor configurations are generated at block 308 (also see Fig. 1 block 105). At block 309, the performance prediction model is executed to predict processor performance.

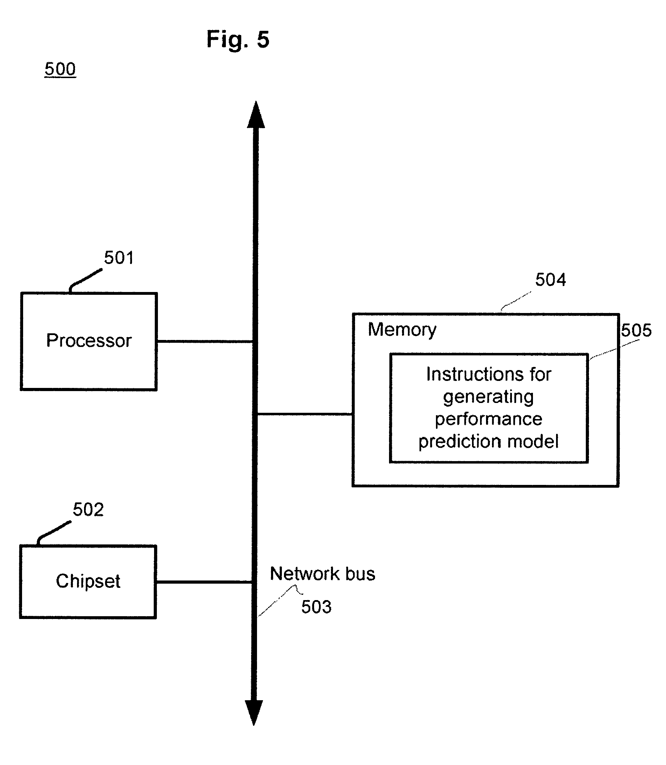

Fig. 5 is a system 500 showing hardware associated with efficiently generating a processor architecture prediction model, according to one embodiment of the invention. In one embodiment, the system 500 includes a processor 501, a chipset 502, and a memory 504 having the instructions 505 to perform the methods discussed above. The above components of the system, in one embodiment are coupled with one another via a network bus 503. In one embodiment, the processor 501 includes logic and memory with the instructions to perform the methods discussed above.

Elements of embodiments are also provided as machine-readable medium (also referred to as computer readable medium) for storing computer executable instructions (e.g., 505 of Fig. 5) that when executed cause a computer or a machine to perform a method (e.g., the methods of Fig. 1 and Fig. 3). The machine-readable medium may include, but is not limited to, memory (e.g., 504 of Fig. 5), flash memory, optical disks, CD-ROMs, DVD ROMs, RAMS, EPROMs, EEPROMs, magnetic or optical cards, or other type of machine-readable media suitable for storing electronic or computer-executable instructions. For example, embodiments of the invention may be downloaded as a computer program (e.g., BIOS) which may be transferred from a remote computer (e.g., a server) to a requesting computer (e.g., a client) by way of data signals via a communication link (e.g., a modem or network connection).

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the element. If the specification or claims refer to "an additional" element, that does not preclude there being more than one of the additional element.

While the invention has been described in conjunction with specific embodiments thereof, many alternatives, modifications and variations will be apparent to those of ordinary skill in the art in light of the foregoing description.

For example, the statistical method VW used for generating the performance predication model can be replaced with other statistical methods including piecewise polynomial regression methods, neural networks, or some variants of support vector machines.

The disclosure of this application includes the following clauses numbered through 30:
1. A method comprising:
   identifying a performance benchmark of a processor;
   sampling a portion of a design space for the identified performance benchmark;
   simulating the sampled portion of the design space to generate training data;
   generating a processor performance model from the training data by modifying the training data to predict an entire design space; and
   predicting performance of the processor for the entire design space by executing the processor performance model.
2. The method of clause 1, wherein the processor performance model is a single performance predicting model representing multiple performance benchmarks.
3. The method of clause 1 further comprising:
   selecting a sample of the predicted performance, the sample representing stimulus for the identified performance benchmark;
   simulating the sample of the predicted performance to generate a performance data; and
   comparing the performance data with the selected sample of the predicted performance.
4. The method of clause 3, wherein the selecting is based on a cost metric and a benefit metric.
5. The method of clause 3, further comprising:
   computing a prediction error via the comparing; and
   modifying the training data by re-sampling a portion of a design space to reduce the computed prediction error.
6. The method of clause 1, wherein predicting performance comprises at least one of:
   predicting power consumption of the processor; and
   predicting instructions-per-second of the processor.
7. The method of clause 1, wherein sampling the portion of the design space for the identified performance benchmark comprises:
   generating random configurations of the processor, each configuration having a parameter-value pair; and
   randomly assigning a value to each parameter of the parameter-value pair, wherein the value determines a size of the design space.
8. The method of clause 7, wherein randomly assigning the value comprises:
   identifying a predetermined range for the value; and
   randomly assigning the value from the predetermined range.
9. The method of clause 1, wherein predicting the performance of the processor for the entire design comprises:
   generating permutations of all configurations of the processor;
   providing the permutations to the processor performance model;
      and
   executing the processor performance model with the provided permutations.
10. The method of clause 1, wherein generating the processor performance model from the training data by modifying the training data to predict the entire design space comprises:
   converting the training data to a single matrix having features and labels associated with the identified performance benchmark;
   providing the single matrix to a statistical application; and
   executing the statistical application.
11. The method of clause 10, wherein the statistical application is a Vowpal Wabbit method.
12. The method of clause 10, wherein the features are in binary form.
13. A computer readable medium having computer readable instructions that, when executed on a computer, cause the computer to perform a method, the method comprising:
   identifying a performance benchmark of a processor;
   sampling a portion of a design space for the identified performance benchmark;
   simulating the sampled portion of the design space to generate training data;
   generating a processor performance model from the training data by modifying the training data to predict an entire design space; and
   predicting performance of the processor for the entire design space by executing the processor performance model.
14. The computer readable medium of clause 13, wherein the processor performance model is a single performance predicting model representing multiple performance benchmarks.
15. The computer readable medium of clause 13 having computer readable instructions that, when executed on the computer, cause the computer to further perform a method, the method comprising:
   selecting a sample of the predicted performance, the sample representing stimulus for the identified performance benchmark;
   simulating the sample of the predicted performance to generate a performance data; and
   comparing the performance data with the selected sample of the predicted performance.
16. The computer readable medium of clause 15, wherein the selecting is based on a cost metric and a benefit metric.
17. The computer readable medium of clause 15 having computer readable instructions that, when executed on the computer, cause the computer to further perform a method, the method comprising:
   computing a prediction error via the comparing; and
   modifying the training data by re-sampling a portion of a design space to reduce the computed prediction error.
18. The computer readable medium of clause 13, wherein predicting performance comprises at least one of:
   predicting power consumption of the processor; and
   predicting instructions-per-second of the processor.
19. The computer readable medium of clause 13, wherein sampling the portion of the design space for the identified performance benchmark comprises:
   generating random configurations of the processor, each configuration having a parameter-value pair; and
   randomly assigning a value to each parameter of the parameter-value pair, wherein the value determines a size of the design space.
20. The computer readable medium of clause 19, wherein randomly assigning the value comprises:
   identifying a predetermined range for the value; and
   randomly assigning the value from the predetermined range.
21. The computer readable medium of clause 13, wherein predicting the performance of the processor for the entire design comprises:
   generating permutations of all configurations of the processor;
   providing the permutations to the processor performance model;
      and
   executing the processor performance model with the provided permutations.
22. The computer readable medium of clause 13, wherein generating the processor performance model from the training data by modifying the training data to predict the entire design space comprises:
   converting the training data to a single matrix having features in binary form and labels associated with the identified performance benchmark;
   providing the single matrix to a statistical application; and
   executing the statistical application.
23. A system comprising:
   a network bus; and
   a memory, coupled with the processor, having instructions to perform a method of predicting performance of a target processor; and
   a processor coupled with the memory via the network bus, the processor having logic to execute the instructions to perform the method comprising:
      identifying a performance benchmark of a target processor;
      sampling a portion of a design space for the identified performance benchmark;
      simulating the sampled portion of the design space to generate training data;
      generating a processor performance model from the training data by modifying the training data to predict an entire design space; and
      predicting performance of the target processor for the entire design space by executing the processor performance model.
24. The system of clause 23, wherein the processor performance model is a single performance predicting model representing multiple performance benchmarks.
25. The system of clause 23, wherein the logic of the processor operable to further perform a method comprising:
   selecting a sample of the predicted performance, the sample representing stimulus for the identified performance benchmark;
   simulating the sample of the predicted performance to generate a performance data; and
   comparing the performance data with the selected sample of the predicted performance, wherein the selecting is based on a cost metric and a benefit metric.
26. The system of clause 25, wherein the logic of the processor operable to further perform a method comprising:
   computing a prediction error via the comparing; and
   modifying the training data by re-sampling a portion of a design space to reduce the computed prediction error.
27. The system of clause 23, wherein predicting performance comprises at least one of:
   predicting power consumption of the processor; and
   predicting instructions-per-second of the processor.
28. The system of clause 23, wherein sampling the portion of the design space for the identified performance benchmark comprises:
   generating random configurations of the processor, each configuration having a parameter-value pair; and
   randomly assigning a value to each parameter of the parameter-value pair, wherein the value determines a size of the design space, wherein randomly assigning the value comprises:
      identifying a predetermined range for the value; and
      randomly assigning the value from the predetermined range.
29. The system of clause 23, wherein predicting the performance of the processor for the entire design comprises:
   generating permutations of all configurations of the processor;
   providing the permutations to the processor performance model; and
   executing the processor performance model with the provided permutations.
30. The system of clause 23, wherein generating the processor performance model from the training data by modifying the training data to predict the entire design space comprises:
   converting the training data to a single matrix having features in binary form and labels associated with the identified performance benchmark;
   providing the single matrix to a statistical application; and executing the statistical application.

Embodiments of the invention are intended to embrace all such alternatives, modifications, and variations as to fall within the broad scope of the appended claims.

## Claims

1. A method comprising:
identifying a performance benchmark of a processor;
sampling a portion of a design space for the identified performance benchmark;
simulating the sampled portion of the design space to generate training data;
generating a processor performance model from the training data by modifying the training data to predict an entire design space; and
predicting performance of the processor for the entire design space by executing the processor performance model.

2. The method of claim 1, wherein the processor performance model is a single performance predicting model representing multiple performance benchmarks.

3. The method of claim 1 further comprising:
selecting a sample of the predicted performance, the sample representing stimulus for the identified performance benchmark;
simulating the sample of the predicted performance to generate a performance data; and
comparing the performance data with the selected sample of the predicted performance.

4. The method of claim 3, wherein the selecting is based on a cost metric and a benefit metric.

5. The method of claim 3, further comprising:
computing a prediction error via the comparing; and
modifying the training data by re-sampling a portion of a design space to reduce the computed prediction error.

6. The method of claim 1, wherein predicting performance comprises at least one of:
predicting power consumption of the processor; and
predicting instructions-per-second of the processor.

7. The method of claim 1, wherein sampling the portion of the design space for the identified performance benchmark comprises:
generating random configurations of the processor, each configuration having a parameter-value pair; and
randomly assigning a value to each parameter of the parameter-value pair, wherein the value determines a size of the design space.

8. The method of claim 7, wherein randomly assigning the value comprises:
identifying a predetermined range for the value; and
randomly assigning the value from the predetermined range.

9. The method of claim 1, wherein predicting the performance of the processor for the entire design comprises:
generating permutations of all configurations of the processor;
providing the permutations to the processor performance model; and
executing the processor performance model with the provided permutations.

10. The method of claim 1, wherein generating the processor performance model from the training data by modifying the training data to predict the entire design space comprises:
converting the training data to a single matrix having features and labels associated with the identified performance benchmark;
providing the single matrix to a statistical application; and
executing the statistical application.

11. The method of claim 10, wherein the statistical application is a Vowpal Wabbit method.

12. The method of claim 10, wherein the features are in binary form.

13. A computer readable medium having computer readable instructions that, when executed on a computer, cause the computer to perform a method as defined in any one of claims 1 to 12.

14. A system comprising:
a network bus; and
a memory, coupled with the processor, having instructions to perform a method of predicting performance of a target processor; and
a processor coupled with the memory via the network bus, the processor having logic to execute the instructions to perform a method as defined in any one of claims 1 to 12.
